# EUROPEAN PATENT APPLICATION

(11) **EP 4 770 416 A2**
(43) Date of publication of application: **01.07.2026**
(21) Application number: 25220340.1
(22) Date of filing: 03.12.2025
(51) Int. Cl.: H10W 90/00, H10W 90/10, H10W 90/20, H10W 70/65, H10W 72/50, H10W 72/60, H02M 7/00

(54) **A MODULE FOR AN ELECTRIC CIRCUIT**

(30) Priority: 03.12.2024 NL 2039231
(71) Applicant: Nexperia B.V., 6534 AB Nijmegen (NL)
(72) Inventor: Simpson, Robin, Manchester (GB); Gong, Wei, Manchester (GB)
(74) Representative: Pjanovic, Ilija

(57) **Abstract**

A goal of the current disclosure is to provide a module for electric circuitry having lower parasitic inductance. This is achieved because in an example, the module for an electric circuit comprises a substrate comprising electric circuitry containing a Direct Current, DC, pad and an Alternating Current, AC, pad. In particular, a first group of semiconductor dies is mounted on the AC pad, whereas a second group of semiconductor dies is mounted on the DC pad. Furthermore, the module comprises a first DC terminal electrically connected to the first group of semiconductor dies, a second DC terminal being electrically isolated from the first DC terminal, and at least electrically connected to the DC pad of the electric circuitry, and an Alternating Current, AC, terminal at least connected to the AC pad of the electric circuitry. Also, the module comprises first connecting means for electrically connecting the first group of semiconductor dies to the AC pad, second connecting means for electrically connecting the second group of semiconductor dies to the DC pad, and third connecting means for electrically connecting the second group of semiconductor dies to the AC pad.

## Description

### TECHNICAL FIELD OF THE DISCLOSURE

The technical field of the present disclosure pertains to power modules, in particular GaN-based power modules with a half-bridge electrical circuit configuration. The disclosure is also applicable to cascode, E-mode and pure D-mode GaN. These modules can be used in electric circuitry for power electronics.

### BACKGROUND

Nowadays, modules, especially power modules, are more prominent in our average day lives. Consumer electronics and electric vehicles are full of them and these modules manage and facilitate the power for these devices.

Unfortunately, these modules inherently have an unwanted byproduct, known as parasitic inductance, which comes from inherent inductance precent in the conductive paths, interconnections, and components. This parasitic inductance can significantly degrade the performance a reliability of the module. Namely, voltages spikes may arise upon switching, wherein the voltage spikes are able to exceed the rated voltage thresholds of the module, thereby causing damage to the module. Furthermore, these voltage spikes result in higher power dissipation creating heat, making the device less efficient and reliable, while also working towards the degradation of the module.

For those reasons it is adamant that power modules are developed that have lower parasitic inductance to mitigate the above-mentioned problems.

### SUMMARY OF DISCLOSURE

It is accordingly a goal of the current disclosure to provide a module for electric circuitry having lower parasitic inductance. This is achieved because in an example, the module for an electric circuit comprises a substrate comprising electric circuitry containing a Direct Current, DC, pad and an Alternating Current, AC, pad. **In** particular, a first group of semiconductor dies is mounted on the AC pad, whereas a second group of semiconductor dies is mounted on the DC pad. Furthermore, the module comprises a first DC terminal electrically connected to the first group of semiconductor dies, a second DC terminal being electrically isolated from the first DC terminal, and at least electrically connected to the DC pad of the electric circuitry, and an Alternating Current, AC, terminal at least connected to the AC pad of the electric circuitry. Also, the module comprises first connecting means for electrically connecting the first group of semiconductor dies to the AC pad, second connecting means for electrically connecting the second group of semiconductor dies to the DC pad, and third connecting means for electrically connecting the second group of semiconductor dies to the AC pad.

An example of a module according to the disclosure as outline above has lower parasitic inductance, due to the electrical path of the module being shortened compared to prior art modules. This is mainly achieved by removing/not needing a second DC pad, which would be known in the art as the DC+ pad. Therefore, the wording "containing" has to be understood as "composed of, or solely composed", such that only an AC pad and one DC pad are present on the module according to the disclosure.

The inventors have found that by electrically connecting the first DC terminal to the first group of semiconductor dies, the electrical path of the module could be significantly shortened. The technical challenges associated with connecting a terminal directly to a (group of) semiconductor die(s), have made it difficult to implement this design in prior art modules. Namely, the electrical connection between the terminal and the semiconductor die must be adequate to provide current and power to the semiconductor die(s) and must be flexible enough to withstand forces acting on the terminal during use or during installation of the module.

In the current patent application this is achieved by providing bond pads on top of the semiconductor dies comprises metal(s) suitable for soldering or sintering, such as nickel (Ni), Silver (Ag), Gold (Au), Copper (Cu), Palladium (Pd), or combinations (of layers) of these. Next, the terminals (AC, first DC, and second DC) are intended to be mounted thereto by manufacturing these terminals with suitable profiles to contact the bond pad on top of the semiconductor die(s), while allowing vertical clearance between the terminal and the edge of the die. Namely, these could be at different electrical potential. Examples of profiles of the terminal surface being mounted to the semiconductor die may be dimples, jogs, coining or other metal forming techniques that create protrusions to match the semiconductor die's metallisation pattern (bond pad).

The inventors have found that utilizing a patterned interface for mounting the terminal (AC, first DC, and/or second DC) reduces the thermomechanical stress between the semiconductor die and the terminal, because there may be a 5 times difference in CTE between the semiconductor die and the terminal. Further, it has been found that segmentation of the terminal-semiconductor die interface also provides stress relief, thereby in some examples the terminal may be provided notches to create sections of terminal with a smaller surface area, which are being mounted to the semiconductor die.

Conventionally, the terminal is manufactured from copper or an alloy of copper suitable for soldering or sintering, however other materials are also possible, e.g. copper-molybdenum, silver, etc., which may have advantageous physical properties over the conventional copper material.

During manufacturing, the terminals are provided as a single lead frame component. Note that it could be more than one lead frame, if the geometry demands this, but one is preferred for cost and manufacturing efficiency. The (single) lead frame offers two functions: 1) as an aid for efficient manufacturing alignment of the terminals; 2) providing mechanical support for the DC+ terminal during manufacturing.

Namely, the (single) lead frame comprising the terminals allows for resting on the semiconductor package by means of parts that rest on the AC/DC-pad or by means of parts that rest on the semiconductor dies. This provides rigidity to the lead frame, minimising free movement of the DC+ terminal, and therefore reduces the potential of inducing a stress on the joint between the first DC (DC+) terminal and the semiconductor die.

Next, the terminals are connected to the semiconductor dies and substrate preferably by soldering, but sintering may also be used. In the latter case, the bonding material may be either silver- or copper-based material. More generally, for both cases, a suitable solder is selected based on compatibility with the metal layers on the chips and the expected peak temperature for the package after initial assembly (e.g., solder attachment to a circuit board).

At a later stage in the manufacturing process, parts of the lead frame are cut away to electrically isolate the terminals for one another. This may either be performed after soldering each terminal or connecting means to the semiconductor dies/substrate, or an encapsulation step may be performed prior to the cutting.

Encapsulation is performed with a hard epoxy-based material, wherein the substrate, the AC/DC pads, and part of the terminals and connecting means are covered with the encapsulant. At least part of the terminals and potentially the connecting means is left uncovered to connect further circuitry to the semiconductor package.

In case cutting has not yet been performed, the lead frame is cut in defined areas to electrically isolate the terminals from one another, and parts are trimmed flush with the encapsulation, while the terminals are left sticking out of the encapsulant.

The hard encapsulation material takes over the role of the lead frame in providing mechanical support for the terminals. Movement of the terminals within the encapsulant is prevented and mechanical stress on the joint between the terminals and chips is minimised - especially for the DC+ terminal, which does not have a secondary connection to the substrate to provide additional mechanical support. The portion of the terminals outside the module can be handled, shaped and distorted without transfer of stress and movement inside the encapsulation.

Therefore, the inventors have been able to reduce the internal circuit path length of the semiconductor package by removing the DC+ pad, which in turn reduces the parasitic inductance of the semiconductor package, making it more reliable.

The expert in the field understands that the DC pad of the invention according to the disclosure, in the art is known as the DC- pad. In a same fashion, it will be understood that the first DC terminal is mounted onto the semiconductor die, which in turn is mounted on the AC pad, is known as the DC+ terminal, and that the second DC terminal is mounted on the DC pad may be known as the DC- terminal.

The module according to the disclosure can utilized a group of semiconductor dies in a cascode, an enhancement-mode (E-mode), or a depletion-mode (D-mode) configuration.

In a first example of the module according to the disclosure, the first group of semiconductor dies and/or the second group of semiconductor dies may each contain one semiconductor die. This example is particularly beneficial for E-mode and D-mode configuration groups of semiconductor dies, wherein only one single semiconductor die typically is needed. This results in that the both the AC and DC pad are connected to a same surface side of said one semiconductor die.

In an alternative, second example of the disclosure, the first group of semiconductor dies and/or the second group of semiconductor dies, each comprises two semiconductor dies. This example is particularly beneficial for cascode configuration groups of semiconductor dies, wherein two semiconductor dies are typically positioned on top of each other. Furthermore, the top semiconductor die is made smaller than the bottom semiconductor die, such that the interface between both semiconductor dies can be connected with connecting means.

In a detail of this second example thereof, in the first group of semiconductor dies, a first semiconductor die is mounted on the AC pad and the second semiconductor die is mounted on the first semiconductor die, and wherein the first DC terminal is electrically connected with the first semiconductor die, and wherein the first connecting means are electrically connected with the second semiconductor die.

In a second example thereof, in the second group of semiconductor dies, a first semiconductor die is mounted on the DC pad and the second semiconductor die is mounted on the first semiconductor die, and wherein the second connecting means are electrically connected with the second semiconductor die and wherein the third connecting means are electrically connected with the first semiconductor die.

In a preferred configuration of the module according to the disclosure (first and second example) the second DC terminal and the second connecting means are formed as a single connecting element. In an alternative configuration, the first connecting means and/or the third connecting means and/or the AC terminal are formed as a single connecting element. In the above two configurations, it is beneficial to form single connecting elements because this reduces the number of processes that need to be performed during manufacturing of the module. Positioning and connecting a single connecting element only has to be performed one, whereas positioned two are even three individual connecting means/terminals would require more time and resources, making the module more expensive in the end.

Furthermore, in the second configuration above, it should be understood to comprise all possible combinations/permutations such as the first connecting means and the third connecting means forming a single connecting element, the first connecting means and the AC terminal forming a single connecting element, the third connecting means and the AC terminal forming a single connecting element, as well as the first connecting element, the third connecting element and the AC terminal forming a single connecting element.

It should be observed, that the substrate of the module of the disclosure can be chosen from a group not limited to a Direct Bonded Copper, DBC, substrate, an Active Metal Brazed, AMB, substrate; or a Ceramic substrate.

The substrate in a module according to the disclosure may be similar to common substrate used in power electronics, such as copper-ceramic-copper substrate, a metal layer on a ceramic substrate, or complete ceramic substrate such as Aluminium Nitride (AIN), Beryllium Oxide (BeO), Alumina (Al₂O₃), Silicon Nitride (SiN/Si₃N₄).

Typically, the top metal layer is etched or removed in particular pattern or layout, thereby creating an electric circuit with isolated and connected parts. The isolated parts are subsequently connected by means of connecting means or terminals to form the eventual module/circuitry. The removal or etching process is performed all the way to the ceramic/insulating layer and the electronic circuitry may be known in the art as the power plane. The benefit is that such substrates and the respective electric circuitry can withstand much higher currents and such substrates have better heat transfer properties compared to traditional lead frames.

In a further detailed example according to the disclosure, the first group of semiconductor dies and/or the second group of semiconductor dies comprise Silicon (Si), Silicon Carbide (SiC), Silicon Nitride (SiN/Si₃N₄), Gallium Oxide (Ga₂O₃), and/or Gallium Nitride (GaN) semiconductor dies. The actual choice of semiconductor material depends on the specific application and requirements of the module. Typically, these material are chosen for their thermal properties, electron mobility, breakdown voltages, switching losses, and/or bandgap.

It should be noted, that in various configurations and examples, the first connecting means and/or the second connecting means and/or the third connecting means and/or the first DC terminal and/or the second DC terminal and/or the AC terminal is formed as bond clip(s) or bond wire(s).

Bond clips or bond wires are particular beneficial means for connecting the semiconductor die to the electric circuitry. Bond wires are easier to position during manufacturing and comprise less material, making them cost-effective, whereas bond clips allow for greater currents to flow through, induce lower inductance and thus result in lower parasitic inductance, and have enhanced thermal performance.

All in all, a module according to the disclosure has lower parasitic inductance, due to the electrical path of the module being shortened compared to prior art modules. Further, beneficial design features have been discussed which depend on the actual implementation and requirements of the module.

### BRIEF DESCRIPTION OF THE DRAWINGS

The disclosure will now be discussed with reference to the drawings, which show in:
Figures 1a and 1b a first example of a module according to the disclosure;
Figures 2a and 2b a second example of a module according to the disclosure;
Figures 3a and 3b a first example of a module according to the disclosure;
Figures 4a and 4b a fourth example of a module according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

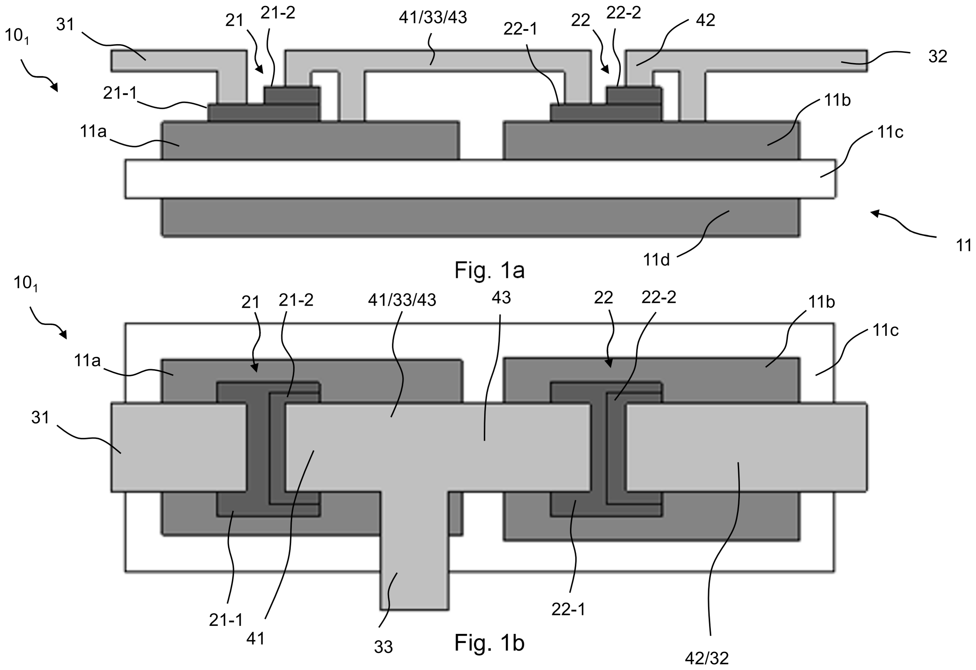

Figures 1a and 1b depict a first example of a module for an electric circuit. The module is indicated with reference numeral 10₁ and comprises a substrate marked with reference numeral 11. The choice of the substrate is less relevant for a proper understanding of the present disclosure, and can be chosen from a group not limited to a Direct Bonded Copper, DBC, substrate, an Active Metal Brazed, AMB, substrate; or a Ceramic substrate. E.g. as depicted in the Figures 1a-1b, 2a-2b, 3a-3b and 4a-4b, the implemented substrate 11 in the module according to the disclosure is a common substrate used in power electronics, such as a copper-ceramic-copper substrate, a metal layer on a ceramic substrate, or complete ceramic substrate such as Aluminium Nitride (AIN), Beryllium Oxide (BeO), Alumina (Al₂O₃). In this particular example, a copper-ceramic-copper substrate 11 is used, formed of a bottom metal (copper) layer 11d and a top metal (copper) layer 11a-11b separated by a ceramic shielding layer 11c.

As shown in the Figures 1a-1b, 2a-2b, 3a-3b and 4a-4b, the top metal layer is etched or removed in particular pattern or layout, thereby creating an electric circuit with isolated and connected parts. The isolated parts (indicated with 11a and 11b) are subsequently connected by means of connecting means or terminals to form the eventual module/circuitry. The removal or etching process is performed all the way to the intermediate ceramic/insulating layer 11c and the electronic circuitry may be known in the art as the power plane. The benefit is that such substrates and the respective electric circuitry can withstand much higher currents and such substrates have better heat transfer properties compared to traditional lead frames.

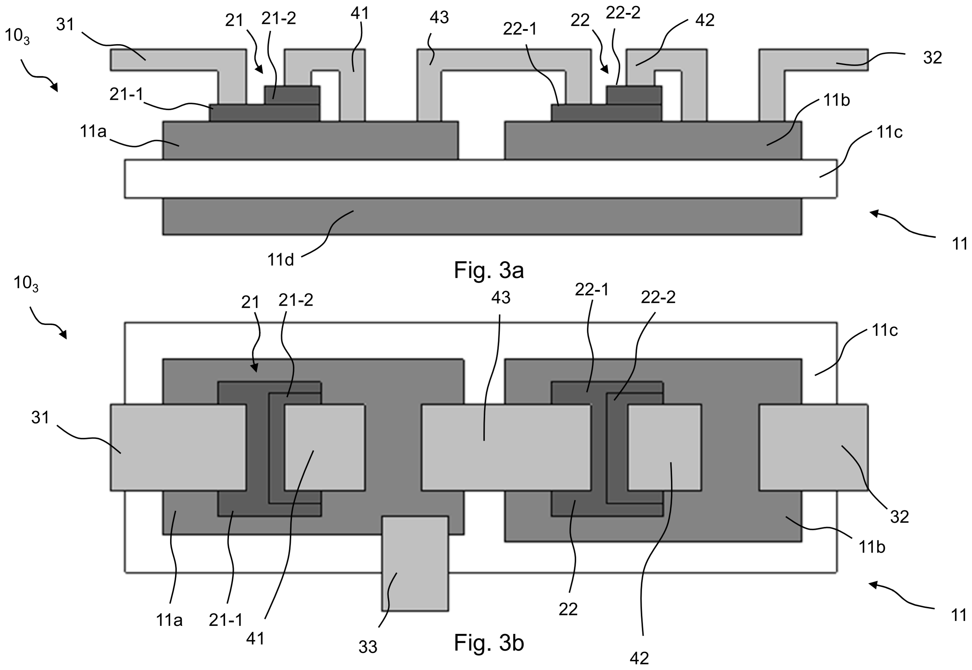

In view of the above and returning to the first example of the module 10₁ shown in Figure 1a and 1b (and the third example of the module 10₃ shown in Figure 3a and 3b), the electric circuitry thus formed in the substate 11 contains a Direct Current, DC, pad 11b and an Alternating Current, AC, pad 11a. A first group 21 of semiconductor dies is mounted on the AC pad 11a, whereas a second group 22 of semiconductor dies is mounted on the DC pad 11b. Note that in this first example, each first group 21 and second group 22 of semiconductor dies each comprises two semiconductor dies, indicated with 21-1/21-2 and 22-1/22-2.

These first and third examples (modules 10₁ and 10₃) are particularly beneficial for cascode configuration groups of semiconductor dies, wherein two semiconductor dies are typically positioned on top of each other. In particular, the top (second) semiconductor die 21-2/22-2 is made smaller than the bottom (first) semiconductor die 21-1/22-1 of each group of semiconductor dies, such that the interface between both semiconductor dies 21-1/21-2 and 22-1/22-2 can be connected with connecting means.

In Figure 1a-1b as well as in Figure 3a-3b, in the first group 21 of semiconductor dies 21-1/21-2, a first semiconductor die 21-1 is mounted on the AC pad 11a and the second semiconductor die 21-2 is mounted on the first semiconductor die 21-1.

Returning to the clarification of the electric circuit, the module 10₁ comprises a first DC terminal 31, which is electrically connected to the first group 21 of semiconductor dies 21-1/21-2. Also, a second DC terminal 32 which is electrically isolated from the first DC terminal 31, is at least electrically connected to the DC pad 11b of the electric circuitry. Reference numeral 33 denotes an Alternating Current, AC, terminal, which is at least electrically connected to the AC pad 11a of the electric circuitry.

First connecting means 41 are provided for electrically connecting the first group 21 of semiconductor dies to the AC pad 11a, second connecting means 42 are provided for electrically connecting the second group 22 of semiconductor dies to the DC pad 11b, and third connecting means 43 are provided for electrically connecting the second group 22 of semiconductor dies to the AC pad 11a.

An example of a module according to the disclosure as outline above has lower parasitic inductance, due to the electrical path of the module being shortened compared to prior art modules. This is mainly achieved by removing/not needing a second DC pad, which would be known in the art as the DC+ pad. Therefore, the wording "containing" has to be understood as "composed of, or solely composed", such that only an AC pad 11a and one DC pad 11b are present on the module according to the disclosure (all examples 10₁-10₂-10₃-10₄).

The inventors have found that by electrically connecting the first DC terminal 31 to the first group 21 of semiconductor dies, the electrical path of the module of all examples 10₁-10₂-10₃-10₄ could be significantly shortened. The technical challenges associated with connecting a terminal directly to a (group of) semiconductor die(s), have made it difficult to implement this design in prior art modules. Namely, the electrical connection between the terminal and the semiconductor die must be adequate to provide current and power to the semiconductor die(s) and must be flexible enough to withstand forces acting on the terminal during use or during installation of the module.

To overcome the instability of the first DC terminal 31 during manufacturing, a few considerations have been made. First, the first DC terminal 31 may be provided protrusions on the connecting portion, which is mounted to the first group of semiconductor dies 21. These increase the surface area and allow the terminal to "bite" into the solder material connecting the first DC terminal 31 and the group of semiconductor dies 21. Next, notches may be provided, thereby separating the first DC terminal 31 having a plurality of smaller connecting areas. These sections can be seen as fingers for the first DC terminal 31, and allow for individual stress adsorption, aiding towards a stronger mechanical connecting between the group of semiconductor dies 21 and the first DC terminal 31. Lastly, the manufacturing process is designed such that mechanical support is provided to the first DC terminal 31 throughout the entire manufacturing process.

An extended explanation is given in the summary of this disclosure, a short summary thereof is provided next. All or at least two terminals/connecting means are provided being connected to each other during the manufacturing, such that mechanical stability can be lent from each other. Subsequently, the terminals/connecting means are soldered/sintered to the substrate 11 and/or groups of semiconductor die(s) 21/22. The soldering could already provide enough mechanical stability to the terminal 31/32, but that cutting and separating may be performed subsequently. However, more mechanical stability can be obtained by encapsulation after soldering/sintering and prior to cutting/separating. The encapsulant covers and protects the semiconductor package, leaving parts of the terminal sticking out for further connecting, and the hard-epoxy material keeps the first DC terminal 31 adequately in place.

Returning to the example of Figure 1a and 1b, it is noted that the first DC terminal 31 is electrically connected with the first semiconductor die 21-1 of the first group 21 of semiconductor dies, and the first connecting means 41 are electrically connected with the second semiconductor die 21-2 of the first group 21 of semiconductor dies as well as with the AC pad 11a.

Similarly, in Figure 1a and 1b, a first semiconductor die 22-1 of the second group 22 of semiconductor dies is mounted on the DC pad 11b and the second semiconductor die 22-2 of the second group 22 of semiconductor dies is mounted on the first semiconductor die 22-1. The second connecting means 42 are electrically connected with the second semiconductor die 22-2 of the second group 22 and the DC pad 11b. Similarly, the third connecting means 43 are electrically connected with the first semiconductor die 22-1 of the second group 22 and the AC pad 11a.

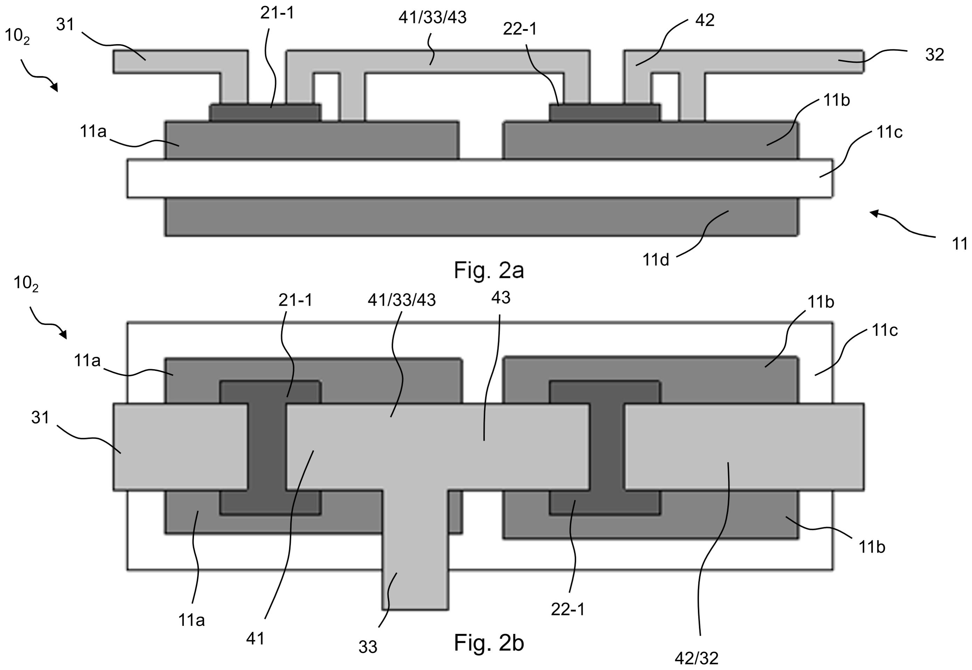

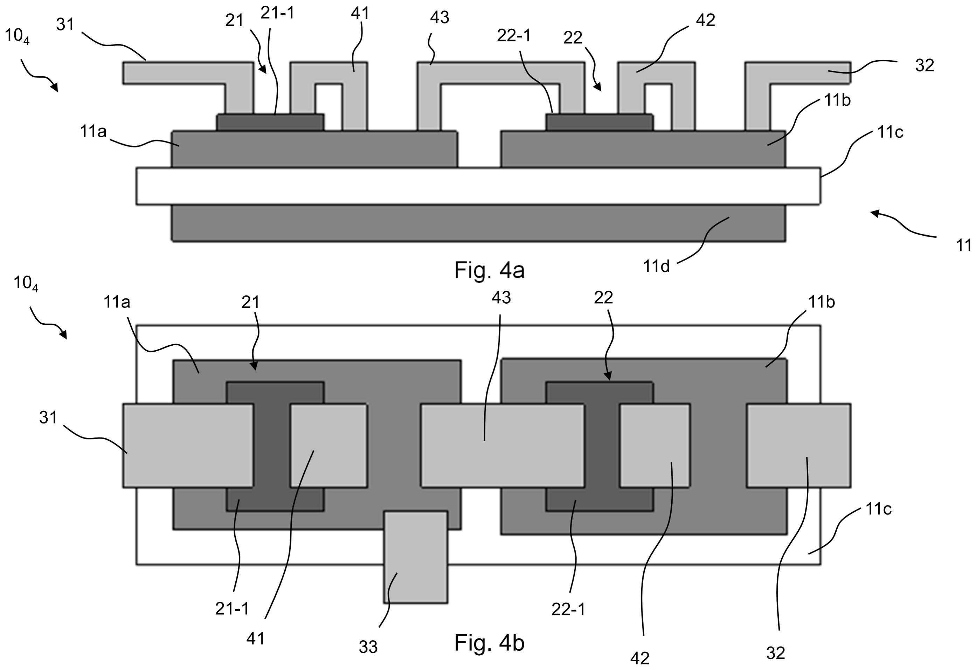

In Figures 2a-2b and 4a-4b, a second and fourth example of a module 10₂ (10₄) according to the disclosure are shown. In these two example, the first group 21 of semiconductor dies and/or the second group 22 of semiconductor dies each contain one semiconductor die 21-1/22-1, contrary to the examples of Figure 1a-1b (module 10₁) and Figure 3a-3b (module 10₃). These examples are particularly beneficial for **E-**mode and D-mode configuration groups of semiconductor dies, wherein only one single semiconductor die typically is needed. This results in that the both the AC pad 11a and the DC pad 11b are connected to a same surface side of said one semiconductor die 21-1 (22-1).

Bond clips or bond wires are particular beneficial means for connecting the semiconductor die to the electric circuitry. Bond wires are easier to position during manufacturing and comprise less material, making them cost-effective, whereas bond clips allow for greater currents to flow through, induce lower inductance and thus result in lower parasitic inductance, and have enhanced thermal performance.

In the first example of the module 10₁ of Figure 1a and 1b, the second DC terminal 32 and the second connecting means 42 are formed as a single connecting element (denoted as 32/42), see the top view of Figure 1b. Similarly, the first connecting means 41 and the third connecting means 43 and the AC terminal 33 are formed as a single connecting element 33/41/43, see the top view of Figure 1b. In these configurations, it is beneficial to form single connecting elements 32/42 and 33/41/42 because this reduces the number of processes that need to be performed during manufacturing of the module 10. Positioning and connecting a single connecting element only has to be performed one, whereas positioned two are even three individual connecting means/terminals would require more time and resources, making the module more expensive in the end.

Similar single connecting elements are also implemented in the second example of the module 10₂ of Figure 2a and 2b. In that example, also the second DC terminal 32 and the second connecting means 42 are formed as a single connecting element (denoted as 32/42), see the top view of Figure 2b. Similarly, the first connecting means 41 and the third connecting means 43 and the AC terminal 33 are formed as a single connecting element 33/41/43, see the top view of Figure 2b.

It should be understood to comprise all possible combinations/permutations are possible for implementing single connecting elements, such as the first connecting means 41 and the third connecting means 43 forming a single connecting element, the first connecting means 41 and the AC terminal 33 forming a single connecting element, the third connecting means 43 and the AC terminal 33 forming a single connecting element, as well as the first connecting element 41, the third connecting element 43 and the AC terminal 33 forming a single connecting element (as shown in Figure 1b and 2b).

In various configurations and examples, the first connecting means 41 and/or the second connecting means 42 and/or the third connecting means 43 and/or the first DC terminal 31 and/or the second DC terminal 32 and/or the AC terminal 33 can be formed as bond clip(s) or bond wire(s).

In the examples of module 10₃ (Figures 3a-3b) and module 10₄ (Figures 4a-4b) no single connecting elements are implemented, but are the first connecting means 41, the second connecting means 42, the third connecting means 43, the second DC terminal 32 and the AC terminal 33 all implemented as separate components, in particular as separate bond clip elements or bond wire elements.

It is observed that in all four examples of the Figures 1a-1b, 2a-2b, 3a-3b and 4a-4b, the DC pad 11b is known as the DC- pad. Likewise, the first DC terminal 31 electrically mounted on the AC pad 11a is known as the DC+ terminal, and the second DC terminal 32 as mounted on the DC pad 11b may be known as the DC- terminal.

In a further detailed example according to the disclosure, the first group 21 of semiconductor dies and/or the second group 22 of semiconductor dies comprise Silicon (Si), Silicon Carbide (SiC), Silicon Nitride (SiN/Si₃N₄), Gallium Oxide (Ga₂O₃), and/or Gallium Nitride (GaN) semiconductor dies. The actual choice of semiconductor material depends on the specific application and requirements of the module. Typically, these material are chosen for their thermal properties, electron mobility, breakdown voltages, switching losses, and/or bandgap.

The modules 10₁-10₂-10₃-10₄ according to the disclosure can utilized a group of semiconductor dies in a cascode, an enhancement-mode (E-mode), or a depletion-mode (D-mode) configuration.

All in all, a module according to the disclosure has lower parasitic inductance, due to the electrical path of the module being shortened compared to prior art modules. Further, beneficial design features have been discussed which depend on the actual implementation and requirements of the module.

### LIST OF REFERENCE NUMERALS

- 10₁₋₄: module for an electric circuit (1^{st}, 2^{nd}, 3^{rd} 4^{th} example)
- 11: substrate
- 11a: an Alternating Current, AC, pad
- 11b: a Direct Current, DC, pad
- 11c: intermediate, ceramic layer of substrate
- 11d: lower metal layer of substrate
- 21: first group of semiconductor dies
- 21-1: first die of first group of semiconductor dies
- 21-2: second die of first group of semiconductor dies
- 22: second group of semiconductor dies
- 22-1: first die of second group of semiconductor dies
- 22-2: second die of second group of semiconductor dies
- 31: first DC terminal
- 32: second DC terminal
- 33: Alternating Current, AC, terminal
- 41: first connecting means
- 42: second connecting means
- 43: third connecting means

## Claims

1. A module for an electric circuit, comprising:
- a substrate comprising electric circuitry containing a Direct Current, DC, pad and an Alternating Current, AC, pad;
- a first group of semiconductor dies mounted on the AC pad;
- a second group of semiconductor dies mounted on the DC pad;
- a first DC terminal electrically connected to the first group of semiconductor dies;
- a second DC terminal, being electrically isolated from the first DC terminal, and at least electrically connected to the DC pad;
- an Alternating Current, AC, terminal at least connected to the AC pad;
- first connecting means for electrically connecting the first group of semiconductor dies to the AC pad;
- second connecting means for electrically connecting the second group of semiconductor dies to the DC pad; and
- third connecting means for electrically connecting the second group of semiconductor dies to the AC pad.

2. The module according to claim 1, wherein the first group of semiconductor dies and/or the second group of semiconductor dies each contain one semiconductor die.

3. The module according to claim 1, wherein the first group of semiconductor dies and/or the second group of semiconductor dies, each comprises two semiconductor dies.

4. The module according to claim 3, wherein, in the first group of semiconductor dies, a first semiconductor die is mounted on the AC pad and the second semiconductor die is mounted on the first semiconductor die, and wherein the first DC terminal is electrically connected with the first semiconductor die, and wherein the first connecting means are electrically connected with the second semiconductor die.

5. The module according to claim 3 or 4, wherein, in the second group of semiconductor dies, a first semiconductor die is mounted on the DC pad and the second semiconductor die is mounted on the first semiconductor die, and wherein the second connecting means are electrically connected with the second semiconductor die and wherein the third connecting means are electrically connected with the first semiconductor die.

6. The module according to any of the preceding claims, wherein the second DC terminal and the second connecting means are formed as a single connecting element.

7. The module according to any of the preceding claims, wherein the first connecting means and/or the third connecting means and/or the AC terminal are formed as a single connecting element.

8. The module according to any of the preceding claims, wherein the substrate is: a Direct Bonded Copper, DBC, substrate; an Active Metal Brazed, AMB, substrate; or a Ceramic substrate.

9. The module according to any of the preceding claims, wherein the first group of semiconductor dies and/or the second group of semiconductor dies comprise Silicon (Si), Silicon Carbide (SiC), Silicon Nitride (SiN/Si₃N₄), Gallium Oxide (Ga₂O₃), and/or Gallium Nitride (GaN) semiconductor dies.

10. The module according to any of the preceding claims, wherein the first connecting means and/or the second connecting means and/or the third connecting means and/or the first DC terminal and/or the second DC terminal and/or the AC terminal is formed as bond clip(s) or bond wire(s).
